Europäisches Patentamt

European Patent Office

Office européen des brevets

(11) Publication number: **0 508 462 A2**

# EUROPEAN PATENT APPLICATION

(21) Application number: **92106255.0**

(22) Date of filing: **10.04.92**

(51) Int. Cl.5: **H01L 23/495**

(30) Priority: **12.04.91 US 685239**

(43) Date of publication of application:
**14.10.92 Bulletin 92/42**

(84) Designated Contracting States:
**DE FR GB IT NL**

(71) Applicant: **TEXAS INSTRUMENTS
INCORPORATED
13500 North Central Expressway
Dallas Texas 75265(US)**

(72) Inventor: **Chiu, Anthony M.
2563 Buttercup Drive
Richardson, Texas 75082(US)**
Inventor: **Baudouin, Daniel A.
2218 Hilton Head
Missouri City, Texas 77459(US)**

(74) Representative: **Schwepfinger, Karl-Heinz,
Dipl.-Ing. et al
Prinz, Leiser, Bunke & Partner Manzingerweg
7
W-8000 München 60(DE)**

(54) Microelectronic device incorporating an improved packaging scheme.

(57) A microelectronic device (10) provides $V_{DD}$ bus 28, contacts 30 and $V_{SS}$ bus 32 disposed in the center portions of semiconductor die (12). Some contacts (30) may be selectively contacted to $V_{DD}$ bus (28) and $V_{SS}$ bus 32 via connective portions (38). A lead finger (16') makes electrical connection with contact (30) by advantageously overlying $V_{DD}$ bus (28) at notch (80) so as to avoid shorting thereto. Thus, integral electrical connection is made to three center terminal groups without resorting to wire bonding techniques to overlie outermost $V_{DD}$ bus (28) and $V_{SS}$ bus (32).

Fig. 5

## BACKGROUND OF THE INVENTION

### 1. Field of the Invention

This invention relates to a microelectronic device incorporating an improved packaging scheme. More particularly, it relates to a microelectronic device which is packaged utilizing Tape Automated Bonding (TAB) on the interior of the chip surface.

### 2. Description of the Prior Art

Increasing component density is one of the driving forces in the microelectronic industry. This phenomenon is particularly acute in the area of memory circuits, for example, dynamic random access memories, or DRAMs. As the number of transistors in a DRAM accelerates into the millions, the need to minimize the inductance of the device circuitry is increased. With the increasing number of components the total inductance of the circuit is augmented so that if new technologies could be developed to decrease the total inductance this would be very advantageous. One facet of this problem is solved by moving contacts to the interior of the chip surface - i.e. moving away from the periphery of the chip surface to the interior (or nonperipheral) areas of the chip surface. This technique has been used with wire-bonding technology to achieve the desired effect of reduced inductance. Examples of the use of wire-bonding are shown in U. S. Patent No. 4,862,245 issued to Pashby and U. S. Patent No. 4,916,519 issued to Ward. However, the wire-bonding technology has attendant drawbacks, such as the high profile of wires, yield reduction due to stress on wires and the circuits during encapsulation, and the fairly elaborate process associated with wire bonding (e.g. use of double-sided tape to adhere lead fingers to the die).

What is needed is a process resulting in a device with non-peripheral electrical connections so as to minimize inductance but having a lower profile, better electrical performance, better manufacturing yields and lower cost.

### SUMMARY OF THE INVENTION

The problems outlined above are in large measure solved by the method in accordance with the present invention. That is to say, the invention hereof provides a higher-yield process resulting in a device with the desirable nonperipheral electrical connections and yet having a lower profile on the semiconductor die. The microelectronic device and associated method in accordance with the present invention include a semiconductor die having at least one nonperipheral terminal disposed adjacent the surface of the semiconductor die and a plurality of lead fingers connected to the die with at least one of the lead fingers in direct contact (as opposed, for example, with a wire-bonding connection) with at least one of the nonperipheral terminals.

The invention provides a microelectronic device comprising:

a semiconductor die having a plurality of terminals disposed thereon; and

a plurality of lead fingers, a first one of said lead fingers in direct contact with a first one of said terminals, wherein said first lead finger overlies a second one of said terminals without contacting said second terminal.

### Brief Description of the Drawings

Fig. 1 is a partial plan view of a prior art semiconductor device;

Fig. 2 is a partial sectional view of a microelectronic device incorporating the present invention;

Fig. 3 is a partial sectional view taken along line 3-3 of Fig. 5;

Fig. 4 is a plan view of a TAB leadframe incorporating the present invention situated over a semiconductor die;

Fig. 5 is partial plan view of the present invention;

Fig. 6 is a partial plan view based on Fig. 5;

Fig. 7 is a sectional schematic view taken along line 7-7 of Fig. 6;

Fig. 8 is a sectional schematic view taken along line 8-8 of Fig. 6; and

Fig. 9 is a sectional schematic view taken along line 9-9 of Fig. 6.

### DESCRIPTION OF THE PREFERRED EMBODIMENT

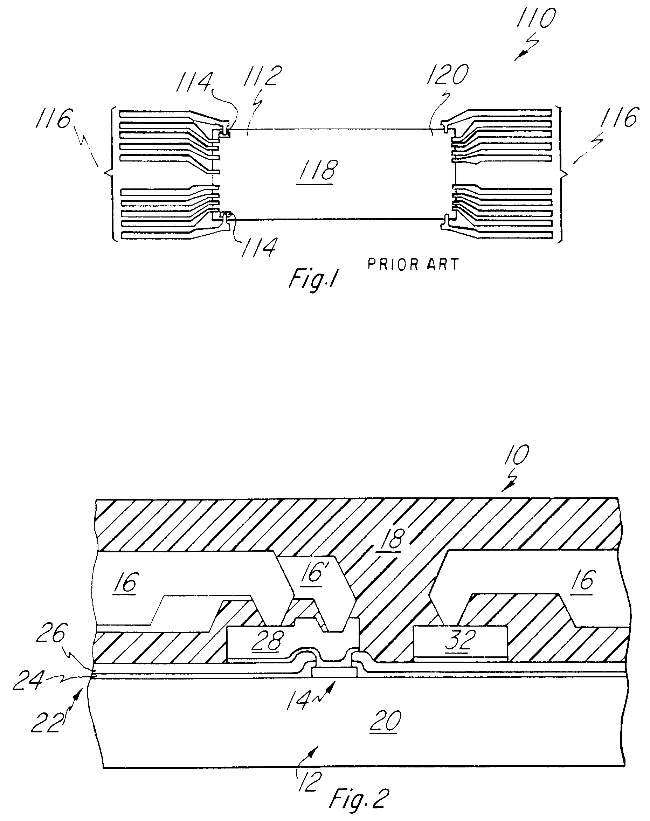

Referring now to the drawings in general, and Fig. 1 in particular, a prior art TAB bonded microelectronic device 110 is displayed. Device 110 is shown with a semiconductor die 112, a plurality of terminals 114, a plurality of lead fingers 116 but with encapsulant omitted for clarity of illustration. Device 110 is made with a TAB process wherein terminals 114 are disposed about the periphery of the surface of die 112 and leads 116 are electrically connected thereto. Note that other peripheral terminals could be disposed at other portions of device 110 as for example by the positions indicated by reference numerals 118 and 120.

In this context, the periphery is the area ranging from the very edge of the chip to about 10-30 mils into the interior of the chip surface, depending on the application. Typically peripheral contacts are placed about 10 mils from the edge of the chip but at the corners the contacts are sometimes placed about 30 mils from the edge.

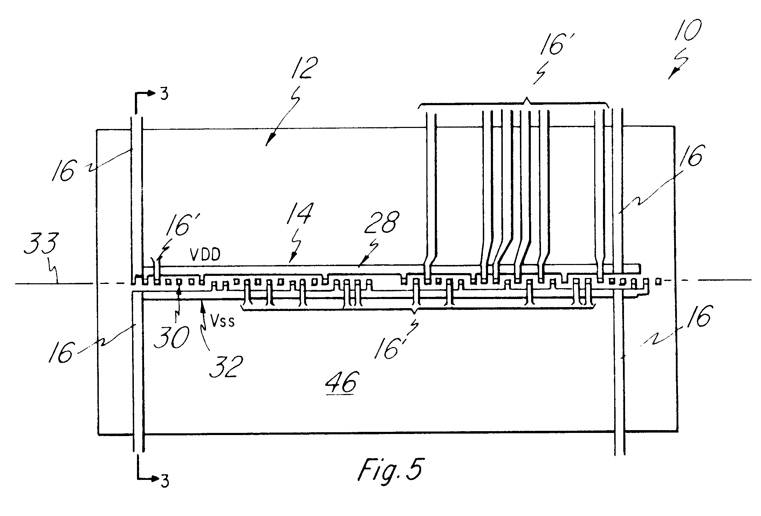

Turning now to the present invention and referring to Fig. 2, a microelectronic device 10 in accordance with the present invention has a semiconductor die 12, a plurality of terminals 14, a plurality of lead fingers 16 and an encapsulant layer 18 which is slightly recessed into the background for clarity of illustration, as will be discussed below. In the preferred embodiment terminals 14 are located in nonperipheral areas on the surface of die 12 in order to minimize inductance and more specifically, terminals 14 are located substantially along the center of die 12 as shown in Fig. 5.

Die 12 includes a substrate 20, and a passivating layer 22 including protective overcoat layer 24 and polyimide layer 26, such a passivating layer being well known in the art. Substrate 20 includes the typical components of the microelectronic art and is generally made of monocrystalline silicon but other substrate materials could also be utilized --for example, but not by way of limitation, germanium and gallium arsenide. In one embodiment, die 12 is a 16 megabit DRAM die such as the type manufactured by Texas Instruments Incorporated of Dallas, Texas, but other types of dies well known in the microelectronic industry, (for example any other type of memory device, logic device or indeed discrete devices and other kinds of integrated devices) could utilize the present invention and are contemplated as being within the realm of the invention.

Fig. 5 is a partial plan view of device 10 with the encapsulant layer 18 as well as a portion of lead fingers 16 removed for clarity of illustration.

Semiconductor die 12 has a plurality 14 of terminals. The plurality of terminals 14 includes a $V_{DD}$ bus 28 and a $V_{SS}$ bus 32. The remaining terminals 14 form a row of discrete contacts 30 substantially aligned along a center axis 33 of die 12.

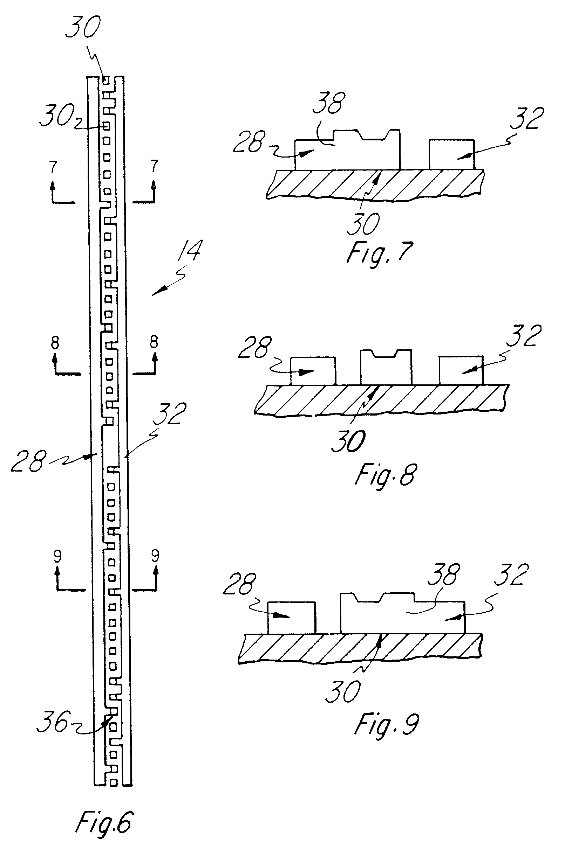

Referring to Figs. 6-9, it can be seen that some of the contacts 30 are connected to one or the other of the buses 28 and 32 such as at reference numeral 36 indicating the connection of one contact 30 to $V_{DD}$ bus 28. Fig. 7 is a sectional schematic view taken along line 7-7 at Fig. 6, showing a contact 30 connected to $V_{DD}$ bus 28 via a conductive connector 38. As will be noted, $V_{SS}$ bus 32 is electrically isolated from the contact 30 at this particular location. Fig. 8 is a sectional view taken along line 8-8 of Fig. 6 showing electrical isolation between buses 28 and 32 and contact 30. Fig. 9 is a sectional view taken along line 9-9 of Fig. 6 schematically showing contact 30 connected to $V_{SS}$ bus 32 via conductive connector portion 38.

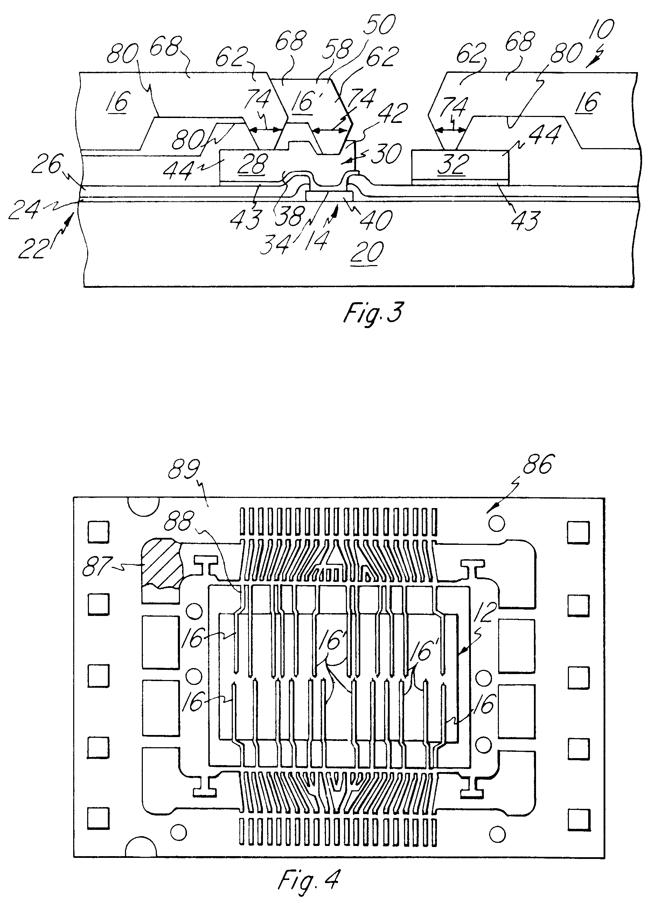

Referring to Fig. 3, contacts 30 generally adjoin the top surface of die 12 and include contact pads 40, bumps 42 as well as the conductive connector structure 38 at this particular location. Generally, $V_{DD}$ bus 28 and $V_{SS}$ bus 32 make electrical contact with substrate 20 via contact pads 40 of contacts 30 as shown. Bumps 42 preferably include titanium-tungsten layer 43 and gold layer 44.

Comparison of Fig. 1 and 5 reveals that the prior art terminals 114 of device 110 are peripheral while in Fig. 5 the $V_{DD}$ bus 28 contacts 30 and $V_{SS}$ bus 32 of terminals 14 are substantially non-peripheral. In the preferred embodiment the non-peripheral configuration is three central rows (i.e. $V_{DD}$ bus 28, $V_{SS}$ bus 32 and a center row of contacts 30. However, any substantially non-peripheral configuration of terminals randomly located inside the periphery, such as individual locations indicated by reference numeral 46 in Fig. 5 or rows or other configurations of terminals not along the center of the die could be used. In addition, nonperipheral terminals could be combined with peripheral terminals and such configurations are contemplated as being within the scope of the invention The above types of configurations are given by way of example and not meant to limit the scope of the invention.

As shown in Fig. 5, some of lead fingers 16 physically contact $V_{DD}$ bus 28, and some physically contact $V_{SS}$ bus 32. Each bus 28 and 32 will typically have one of lead fingers 16 in contact with each end of the bus. The remaining lead fingers 16, shown as 16' in Fig. 5 are physically connected to contacts 30.

Fig. 3 illustrates how lead finger 16' can physically connect to contacts 30 without contacting either $V_{DD}$ bus 28 or $V_{SS}$ bus 32. As shown, each lead finger 16 has a head 62 and a neck 68. The heads 62 each have a bump 74. The necks 68 each have a notch or recess 90.

As shown in Figs. 3 and 5, it can be seen that notches 80 allow bumps 74 of lead fingers 16' to contact terminals 14 and yet overlie $V_{DD}$ bus 28 and $V_{SS}$ bus 32. Buses 28 and 32 pass through the notches 80 in lead fingers 16'.

In other words, notch 80 allows the TAB process to be used as an alternative to wire bonding since lead fingers 16' can overlie $V_{DD}$ bus 28 and $V_{SS}$ bus 32 without making electrical contact thereto. In this regard it will be noted that bumps 42 are helpful in facilitating the geometry of necks 68 overlying $V_{DD}$ bus 28 and $V_{SS}$ bus 32 but that other configurations and geometries might be utilized --for example bump- on-chip without a bump on lead finger or vice versa. Indeed the invention contemplates that geometries could be utilized where bumps were not necessary at all. For example, bumps 42 on contacts 30 could be formed higher than bus 28 or bus 32 so that notches 80 and bumps 74 would not be necessary for lead fingers 16' to overlie either bus 28 or bus 32 without making electrical contact thereto.

Lead fingers 16 are preferably etched to form notches 80 shown in Fig. 3. Other methods of forming notches 80 and bumps 74, for example forming or coining, well known in the art, can be used.

Referring to Fig. 4, the process of making device 10 will now be described. First, leadframe 86 from a TAB tape is positioned over die 12, all of which is well known in the art. After appropriate bonding, leadframe 86 is attached to a molded carrier ring 87 (partially shown). An initial trim is performed to isolate the lead fingers from each other and from outer, frame portion 89 prior to testing. It will be noted that lead fingers 16 in Fig. 4 are substantially planar at this point in the process. At the end of testing, the lead fingers 16 are further trimmed (as at reference numeral 88) to physically separate lead fingers 16 for board assembly.

As shown in Fig. 3, bumps 42 on die 12 are deposited using an electroplating technique commonly known as wafer bumping. The power bus 28 and ground bus 32, are patterned on die 12 simultaneously with the bumps 42 for the bond pads 40 and the connectors 38 to the power and ground bond pads of the integrated circuit. There are no additional process steps to fabricate these buses. The plated buses 28, 32 serve as common power source to all the memory cells on the substrate.

Leadframe 86 and die 12 are joined together by a thermal compression process, preferably at 500°C and 150 grams per joint. Under such pressure and temperature conditions, the metals on gold/copper leadframe 86 will diffuse into the gold on the bumps 42 on die 12 and vice versa. The diffusion results in a strong metal-to-metal bond.

The final step in the process is forming encapsulating layer 18 along with attendant structure, as is well known in the art (see Fig. 2). The resulting device 10 has nonperipheral terminals, thereby lowering the circuit inductance as discussed above, yet having TAB lead fingers directly connected to terminals as opposed to the structure in a device manufactured in a wire bonding process. Furthermore, wire bonding results in a profile of about 8 mils from the uppermost portions of the wire to the top surface of the die, while according to the present invention a profile of about 4 mils from the top of the lead finger to the die is achieved. Since the profile of the electrical connection (i.e. lead finger to terminal) is lower, the encapsulant profile can also be lower in the present invention, resulting in the ability to achieve greater packing density of devices 10. The present invention also avoids other problems associated with wire bonding (e.g. double sided tape used to adhere lead fingers to the chip in the wire bonding process). Furthermore, there is less stress for the TAB process than for wire bonding as is well known in the art and thus a higher manufacturing yield is achieved, another advantage of the present invention.

Although the invention has been described herein with reference to its preferred embodiment and certain described alternatives, it is to be understood that this description is by way of example only, and is not to be construed in a limiting sense. It is to be further understood that numerous details of the embodiments of the invention, and additional embodiments of the invention will be apparent to, and be made by persons of ordinary skill in the art having reference to this description. It is contemplated that all such changes and additional embodiments are within the spirit and true scope of the invention as claimed below.

In particular, in one aspect of the present invention, a micro-electronic device comprises:
a semiconductor die presenting a centre axis, and having a first set, a second set, and a third set of terminals disposed on a surface of said semiconductor die, said first set including a substantially linear positive voltage bus, said third set including a substantially linear ground voltage bus, and said second set including a substantially linear row of discrete contacts substantially aligned along said centre axis of said die, said positive voltage bus and said ground voltage bus proximal with, substantially parallel to, and on opposite sides of said row of discrete contacts; and
a first set, a second set, and a third set of lead fingers, each of said lead fingers having a head and a neck, said first set of lead fingers formed so that said heads of said first set of lead fingers make direct contact with said positive voltage bus, said third set of lead fingers make direct contact with said ground voltage bus, said neck portions of said second set of lead fingers having selectively thinned portions.

Said second set of lead fingers formed so that said heads of said second set of lead fingers make direct contact with said discrete row of contacts, said necks of said second set of lead fingers overlying either said positive voltage bus or said ground voltage bus without said second set of lead fingers contacting respectively either said positive voltage bus or said ground voltage bus.

Preferably, at least one of said discrete contacts is connected to said positive voltage bus at least another one of said discrete contacts is connected to said ground voltage bus.

## Claims

1. A method of making a microelectronic device comprising the following steps:

providing a semiconductor die having at least one nonperipheral electrical terminal disposed thereon; and
providing a plurality of lead fingers connected to said die, at least one of said lead fingers being directly connected to one of said nonperipheral terminals.

2. A method of making a microelectronic device as claimed in claim 1 and wherein said plurality of lead fingers are provided on a lead frame.

3. A method of making a microelectronic device as claimed in claim 1 or claim 2 and having a plurality of electrical terminals disposed thereon, comprising the step of:
contacting a first one of said terminals with one of said lead fingers,
said lead finger overlying a second one of said terminals without contacting the second one.

4. The method of claim 3 wherein said one of said lead fingers is shaped to include a neck and ahead, said neck overlying said second one of said terminals without contacting said first one of said terminals.

5. The method of any preceding claim wherein said lead fingers each have a head and a neck and including the further step of removing said selected portions of at least one of said necks of said lead fingers by etching.

6. A method as claimed in any preceding claim and wherein said plurality of lead fingers are provided as a TAB lead frame including the step of: providing a TAB tape having a series of substantially identical lead frames; separating one of said lead frames from the remainder of said tape.

7. A microelectronic device comprising a semiconductor die having at least one non peripheral electrical terminal disposed thereon; and
a plurality of lead fingers connected to said die, at least one of said lead fingers being directly connected to one of said nonperipheral terminals.

8. The microelectronic device of claim 7 wherein said semiconductor die has a plurality of terminals disposed thereon, said terminals substantially being disposed in an axial configuration.

9. The microelectronic device of any preceding claim and having a plurality of terminals disposed thereon and wherein a first one of said lead fingers is in direct contact with a first one of said terminals, wherein said first finger overlies a second one of said terminals without contacting said second one.

10. The microelectronic device of claim 9 wherein at least said first one of said terminals is non peripheral.

11. The microelectronic device as claimed in any preceding claim and wherein a first set of terminals forms a substantially central axial configuration.

12. The microelectronic device of claim 11 wherein a second set of said terminals forms a substantially axial configuration substantially parallel to said axial configuration of said first set of terminals.

13. The microelectronic device as claimed in any preceding claim and wherein at least one terminal includes conductive bumps connected to said die.

14. The microelectronic device as claimed in any of claims 10 to 13 in that they depend from claim 9 and wherein one or more of said lead fingers includes conductive bumps disposed thereon.

15. The microelectronic device of any preceding claim wherein said semiconductor die is a DRAM die.

16. A lead frame for providing the plurality of lead fingers for a microelectronic device as claimed in any preceding claim.

17. The lead frame of claim 16 wherein the lead frame is a TAB lead frame.

PRIOR ART

Fig.1

Fig.2

Fig. 3

Fig. 4

Fig.5

Fig.6

Fig.7

Fig.8

Fig.9